# EUROPÄISCHE PATENTSCHRIFT

(11) **EP 2 859 131 B1**
(45) Veröffentlichungstag und Bekanntmachung des Hinweises auf die Patenterteilung: **06.03.2019**
(21) Anmeldenummer: 13726698.7
(22) Anmeldetag: 08.05.2013
(51) Int. Cl.: C23C 16/27, H01J 37/32, C23C 16/48

(54) **PLASMA-UNTERSTÜTZTES CHEMISCHES GASPHASENABSCHEIDUNGS-VERFAHREN MIT ERHÖHTER PLASMADICHTE UND VORRICHTUNG ZUR UMSETZUNG DES VERFAHRENS**
PLASMA-ASSISTED CHEMICAL VAPOR DEPOSITION METHOD HAVING INCREASED PLASMA DENSITY AND DEVICE FOR IMPLEMENTING THE METHOD
PROCÉDÉ DE DÉPÔT CHIMIQUE EN PHASE GAZEUSE ASSISTÉ PAR PLASMA À DENSITÉ ÉLEVÉE ET DISPOSITIF DE MISE EN OEUVRE DU PROCÉDÉ

(30) Priorität: 08.06.2012 DE 102012209650
(43) Veröffentlichungstag der Anmeldung: 15.04.2015
(73) Patentinhaber: Fraunhofer-Gesellschaft zur Förderung der angewandten Forschung e.V., 80686 München (DE)
(72) Erfinder: REYNVAAN, Jacob, A-8010 Graz (AT); GRÜNWALD, Johannes, A-5660 Taxenbach (AT)
(74) Vertreter: advotec.
(86) Internationale Anmeldenummer: PCT/EP2013/059643
(87) Internationale Veröffentlichungsnummer: WO 2013/182372

(56) Entgegenhaltungen:
- EP-A2- 1 990 443
- BACHMANN P K ET AL: "Diamond deposition technologies", DIAMOND AND RELATED MATERIALS, ELSEVIER SCIENCE PUBLISHERS, AMSTERDAM, NL, Bd. 1, Nr. 10-11, 16. November 1992 (1992-11-16), Seiten 1021-1034, XP024178376, ISSN: 0925-9635, DOI: 10.1016/0925-9635(92)90073-W [gefunden am 1992-11-16]
- MUJAWAR M A ET AL: "Properties of a differentially pumped constricted hollow anode plasma source;Properties of a differentially pumped constricted hollow anode plasma source", PLASMA SOURCES SCIENCE AND TECHNOLOGY, INSTITUTE OF PHYSICS PUBLISHING, BRISTOL, GB, Bd. 20, Nr. 1, 24. Januar 2011 (2011-01-24), Seite 15024, XP020204311, ISSN: 0963-0252, DOI: 10.1088/0963-0252/20/1/015024
- ZHU X ET AL: "CVD diamond thin film technology for MEMS packaging", DIAMOND AND RELATED MATERIALS, ELSEVIER SCIENCE PUBLISHERS, AMSTERDAM, NL, Bd. 15, Nr. 2-3, 4. Oktober 2005 (2005-10-04), Seiten 254-258, XP028000453, ISSN: 0925-9635, DOI: 10.1016/J.DIAMOND.2005.08.009 [gefunden am 2006-02-01]
- TIRON V ET AL: "Ion Energy Distribution in Thermionic Vacuum Arc Plasma", IEEE TRANSACTIONS ON PLASMA SCIENCE, IEEE SERVICE CENTER, PISCATAWAY, NJ, US, Bd. 39, Nr. 6, 10. März 2011 (2011-03-10), Seiten 1403-1407, XP011477677, ISSN: 0093-3813, DOI: 10.1109/TPS.2011.2108671

## Beschreibung

Die Erfindung betrifft ein Verfahren und eine Vorrichtung zur Beschichtung von Oberflächen eines Substrats nach der Methode der Plasma-unterstützten chemischen Gasphasenabscheidung.

Die chemische Gasphasenabscheidung (CVD - Chemical Vapor Depostion) bezeichnet ein Verfahren zur Beschichtung von Substratoberflächen, bei dem in einer Reaktionskammer auf Grund chemischer Reaktionen der zugeführten Reaktionsgase ein Feststoff aus der Gasphase an der Oberfläche eines Substrates abgeschieden wird. Der sich niederschlagende Feststoff bewirkt auf der Substratoberfläche ein Schichtwachstum, dessen Homogenität und Wachstumsrate durch Prozessparameter wie Gaskonzentration und Gasdruck oder Substrattemperatur beeinflussbar sind. Eingesetzt wird die chemische Gasphasenabscheidung beispielsweise in der Halbleiterindustrie, um kristallines Silizium oder Siliziumdioxid auf Waferoberflächen abzuscheiden. Neben dem Einsatz in der Halbleiterfertigung findet das CVD-Verfahren eine bevorzugte Anwendung in der Abscheidung künstlicher kristalliner Diamantschichten, beispielsweise um extrem verschleißfeste mechanische Bauelemente herzustellen oder im Bereich der elektrochemischen Abwasserbehandlung Bor-dotierte Diamant-beschichtete Elektroden mit hohem Wirkungsgrad bereitzustellen.

Es existieren verschiedene Varianten des CVD-Verfahrens, die unter anderem nach der Art der Zuführung der Aktivierungsenergie unterschieden werden können. Neben rein thermisch aktivierten Prozessen, bei denen die Reaktanden durch Zufuhr thermischer Energie bei hohen Temperaturen gespalten werden und die so entstandenen Produkte zum Schichtaufbau beitragen, erfolgt in dem Plasma-unterstützten CVD-Verfahren zusätzlich eine Anregung der Reaktionsgase durch ein Plasma. Die chemischen Verbindungen der Prozessgase werden dabei teilweise ionisiert, wobei die Ionen auf das zu beschichtende Substrat treffen und neben den durch Aufbrechen der Moleküle entstandenen Radikalen zu dem Schichtwachstum beitragen. Die Wachstumsrate der abzuscheidenden Schicht ist abhängig von der Plasmadichte, also von der Ionenkonzentration. Je höher diese Ionenkonzentration in dem Plasma ist, desto schneller vollzieht sich im Allgemeinen das Schichtwachstum, Patentdokument US 5414540 offenbart ein PECVD Verfahren zur Diamantabscheidung.

Die Anregung dieses Hintergrundplasmas kann durch Feldionisation mittels eines hochfrequenten elektromagnetischen Feldes (Mikrowellen) erfolgen. Daneben ist auch eine Anregung mit Laserstrahlung oder durch Stoßionisation mit hochenergetischen Teilchen - meistens Elektronen - möglich.

Insbesondere bei industriellen Anwendungen findet die Methode der Plasma-unterstützten CVD-Beschichtung zunehmend Verwendung. In diesem wettbewerblichen Umfeld stellt der Beschichtungsprozess einen nicht unerheblichen Zeit- und Kostenfaktor in der Produktion dar, so dass man bestrebt ist, diesen Prozessschritt zu beschleunigen und damit die Kosten zu senken.

Der vorliegenden Erfindung liegt somit die Aufgabe zu Grunde, den Beschichtungsprozess in einem Plasma-unterstützten CVD-Verfahren im Hinblick auf eine Senkung der Herstellungskosten zu beschleunigen. Diese Aufgabe wird in Verbindung mit dem Oberbegriff des Anspruchs 1 dadurch gelöst, dass die Plasmadichte an der Oberfläche des Substrats durch die Bildung eines Fireballs, der sich an einer positiv vorgespannten Elektrodenoberfläche ausbildet, erhöht wird. Grundgedanke der vorliegenden Erfindung ist es, die in dem Plasma vorherrschende Ionenkonzentration - die ein Abbild der Plasmadichte ist - zu erhöhen, um zu erreichen, dass sich mehr Ionen auf dem Substrat anlagern und das Schichtwachstum fördern. Erfindungsgemäß wird die Ionenkonzentration dadurch erhöht, dass an der Oberfläche des zu beschichtenden Substrats ein Fireball gebildet wird.

Aus dem Stand der Technik ist bekannt, dass sich in Plasmaprozessen an Elektrodenoberflächen spontan kleine hell leuchtende Erscheinungen bilden. Diese Ionisierungsvorgänge werden auch als Fireballs charakterisiert. Dabei wird eine Elektrode in ein existierendes Hintergrundplasma eingebracht und auf ein positives Potential gelegt. Zunächst bildet sich eine elektronenreiche Debye-Schicht, die dazu tendiert, das positive Elektrodenpotential abzuschirmen, um die Quasineutralität des umgebenden Plasmas aufrechtzuerhalten. Übersteigt die angelegte positive Spannung an der Elektrode das Ionisierungspotential des Prozessgases, kommt es innerhalb der Debye-Schicht zu zusätzlichen Ionisierungsprozessen, die die Raumladung nahe der Elektrodenoberfläche so verändern, dass sich die nahezu zweidimensionale, ebene Schicht an der Elektrodenoberfläche zu dreidimensionalen Gebilden aufbläht. Diese dreidimensionalen Strukturen werden als anode spots oder neuerdings als Fireballs bezeichnet.

Wird nun in der Nähe der Oberfläche des zu beschichtenden Substrats ein derartiger Fireball gebildet, so entwickelt sich eine Plasmakonfiguration mit örtlich begrenzter erhöhter Dichte und Teilchentemperatur. Die erhöhte Ionenkonzentration beschleunigt das Schichtwachstum auf dem in den Wirkungsbereich des Fireballs eingebrachten Substrats, erhöht also die Abscheiderate und führt dazu, dass gewünschte Schichtstärken mit kürzerer Aufenthaltsdauer des Substrats in der Reaktionskammer bzw. bei kontinuierlichen Beschichtungsprozessen mit höherer Vorschubgeschwindigkeit erreicht werden. Damit trägt der erfindungsgemäße Einsatz des Fireballs in einem Plasma-unterstützten CVD-Verfahren dazu bei, den Beschichtungsprozess zu beschleunigen und die Kosten der Beschichtung zu reduzieren.

Als weiteren Vorteil benötigt das erfindungsgemäße Verfahren weniger Energie und verursacht damit geringere Energiekosten als nach dem Stand der Technik verwendete Plasma-unterstützte CVD-Verfahren, da für die Erzeugung des Fireballs weniger (Primär-) Elektronen erforderlich sind und daher ein Großteil der Leistung zur Erzeugung des Hintergrundplasmas wegfällt.

In einer bevorzugten Ausgestaltung wird der Fireball als invertierter Fireball angeregt.

Versuchsergebnisse nach dem Stand der Technik zeigen, dass sich Fireballs nicht nur außerhalb der festen Elektroden an deren Elekrodenoberfläche ausbilden, sondern auch im Innenraum von hohlen kugelförmigen Elektroden, die durch ein hoch transparentes Gitternetz gebildet werden. Erstmals erwähnt wurden diese "inverted fireballs" in der Veröffentlichung "Transit time instabilities in an inverted fireball. I. Basic properties" und "Transit time instabilities in an inverted fireball. II. Mode jumping and nonlinearities", R. L. Stenzel, J. Gruenwald et al., Physics of Plasmas, Vol. 18, Number 1.

In vorteilhafter Weise ist die Ionenkonzentration in diesem Gebiet deutlich erhöht und kann um den Faktor 40 und mehr gegenüber der Plasmadichte ohne Fireball-Anregung ansteigen. Durch die hohen Plasmadichten und hohen Ionentemperaturen im Inneren des Fireballs kann der Prozessdruck und somit der Prozessgasverbrauch wesentlich reduziert werden, was zu weiteren Kosteneinsparungen führt.

In weiterer vorteilhafter Ausgestaltung bildet sich der invertierte Fireball in einem Innenraum einer hohlraumbildenden Gitterelektrode aus. Eine hohlraumbildende Gitterelektrode wird in ein vorhandenes Hintergrundplasma eingebracht und mit einem positiven Potential vorgespannt. Sobald die positive Vorspannung das Ionisierungspotential des verwendeten Prozessgases überschreitet, entsteht im Innenraum der hohlraumbildenden Gitterelektrode ein invertierter Fireball. Dabei erfolgt dessen Ausbildung durch die von dem Gitterpotential beschleunigten Elektronen, die nicht von dem Gitter absorbiert werden und daher zusätzliche Stoßionisationen hervorrufen können. Da sich wie bei der Betrachtung von Elektrodenoberflächen auch um die einzelnen Drähte des Gitters eine elektronenreiche Debye-Schicht bildet, die dazu tendiert, die positive Raumladung des umgebenden Plasmas abzuschirmen, kommt es ab einem gewissen Punkt zur Bildung von zusammenhängenden Äquipotentialflächen entlang der Gitter-(hüll-)fläche. Dieser Punkt ist dadurch gekennzeichnet, dass sich die Debye-Schichten überlappen und dadurch die Gitterzwischenräume für langsame Elektronen "abschließen".

An das aus elektrisch leitfähigem Material bestehende Substrat kann zur Steuerung der Wachstumsbedingungen, beispielsweise über die Variation der Substrattemperatur, eine elektrische Vorspannung angelegt werden.

Mit Vorteil wird das Hintergrundplasma durch Laserstrahlung angeregt. Die Bestrahlung kann mit einer fokussierten Laserstrahlung erfolgen, die zudem die Effizienz der Energieübertagung an das Reaktionsgas steigert.

Als weitere Möglichkeit kann das Hintergrundplasma durch Zufuhr elektrischer und/oder magnetischer Energie angeregt werden. Dabei wird über eine Antennenvorrichtung vorzugsweise ein hochfrequentes elektromagnetisches Mikrowellenfeld in die Reaktorkammer eingekoppelt, das eine elektromagnetische Gasentladung auslöst. Daneben sind auch rein kapazitiv oder rein induktiv angeregte Plasmen möglich.

In vorteilhafter Weise wird die Energiezufuhr pro Zeiteinheit in das Hintergrundplasma nach Ausbildung des Fireballs verringert. Da der in einem Fireball ablaufende Ionisierungsprozess nahezu selbsterhaltend abläuft, kann nach der erstmaligen Zündung des Fireballs die externe Plasmaquelle nahezu völlig abgeschaltet werden, wobei der Fireball dennoch erhalten bleibt.

Bestehende Verfahren zur Erzeugung von Schichten aus Titannitrid, Siliziumnitrid, Siliziumoxid, Silizium/Metall-Verbindungen sowie aus Zinnoxid und Siliziumcarbid werden durch die Anwendung des Verfahrens beschleunigt, ebenso wie alle auf Tetraethylorthosilikat (TEOS) basierende Abscheidungen von Siliziumcarbiden, Oxiden, Nitriden, Oxinitriden und Abscheidungen von Kohlenstoff, z.B. als Diamant.

Insbesondere eignet sich das Verfahren zur Abscheidung folgender Substanzen:
Abscheidung einer Diamantschicht aus Methan und Wasserstoff,
Abscheidung einer mit Bor dotierten Diamantschicht unter Zugabe einer organischen Borverbindung zu dem Reaktionsgas,
Abscheidung einer Siliziumnitrid-Schicht aus Ammoniak und Dichlorsilan,
Abscheidung einer Siliziumoxid-Schicht aus Silan und Sauerstoff oder Tetraethylothosilikat (TEOS),
Abscheidung einer Silizium/Metall-Verbindung aus Wolframhexafluorid,
Abscheidung einer Siliziumcarbid-Schicht aus Wasserstoff und Methylen- Trichlor-Silan,
Abscheidung von Titannitrid aus Tetrakis(dimethylamino)titan 1 (TDMAT) und Stickstoff,
Abscheidung von Siliciden wie Wolfram-, Cobalt- oder Nickelsilicid aus organischen Verbindungen wie z.B. Wolfram(VI)-fluorid 3,
Abscheidung von Zinnoxid-Schichten aus Zinn-Chlorid oder Zinn-organischen Verbindungen mit Wasserdampf oder Sauerstoff auf Glas, Abscheidung von Borcarbid.

Bezogen auf eine Vorrichtung wird die der Erfindung zu Grunde liegende Aufgabe in Verbindung mit dem Oberbegriff des Anspruchs 9 gelöst durch eine in der Reaktionskammer angeordnete, positiv vorgespannte Elektrodenoberfläche zur Ausbildung eines Fireballs.

Diese Vorrichtung setzt das beschriebene erfindungsgemäße Verfahren um. Ausgehend von einer bekannten Vorrichtung, wie sie bei der Plasma-unterstützten chemischen Gasphasenabscheidung zur Anwendung gelangt, wird eine in ein existierendes Hintergrundplasma eingebrachte Elektrode auf ein positives Potential gelegt. Bei Erhöhung des Elektrodenpotentials bilden sich ab einem bestimmten Potentialwert die als Fireballs bezeichneten hell leuchtenden Erscheinungen aus, in deren Umgebung die Ionenkonzentration ansteigt und zu einem schnelleren Schichtwachstum führt.

Mit Vorteil ist die Elektrodenoberfläche als hohlraumbildende Gitterelektrode ausgeführt, in deren Innenraum sich ein invertierter Fireball ausbildet. Die hohlraumbildende Gitterelektrode lässt in ihrem Innenraum einen invertierten Fireball mit nochmals gesteigerter Ionenkonzentration entstehen, der nahezu selbsterhaltend ist und somit über einen verminderten Energieeintrag in vorteilhafterweise die Prozesskosten weiter reduziert.

Bevorzugt ist das Substrat elektrisch isoliert im Wirkungsbereich des Fireballs angeordnet. Um die durch den Fireball erhöhte Ionenkonzentration für das Schichtwachstum auf dem Substrat nutzen zu können, ist das Substrat in einem Bereich nahe des Fireballs angeordnet, in dem eine merkliche Erhöhung der Ionenkonzentration vorliegt. Die elektrisch isolierte Anordnung ermöglicht in Verbindung mit einer Ausführung des Substrats aus elektrisch leitfähigem Material eine separate Vorspannung des Substrats zur gezielten Beeinflussung des Prozessverlaufs. Bevorzugterweise besteht das Substrat daher aus Metall oder Graphit oder Siliziumcarbid oder Silizium oder einem Komposit aus diesen Substanzen oder einer Mischung aus diesen Substanzen.

Zur Herstellung der hohlraumbildenden Gitterelektrode wird wegen seiner Temperaturbeständigkeit vorzugsweise Wolfram eingesetzt.

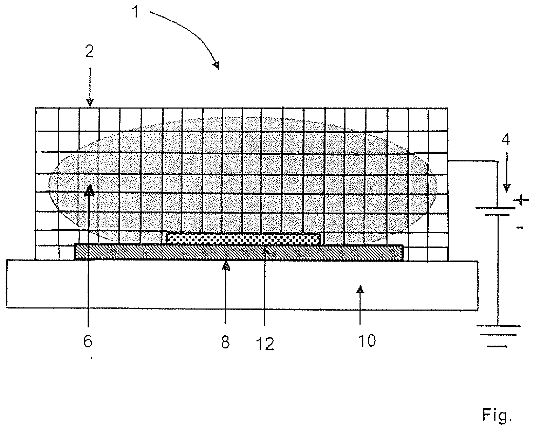

Weitere vorteilhafte Ausgestaltungsmerkmale ergeben sich aus der nachfolgenden Beschreibung und der Zeichnung, die eine bevorzugte Ausführungsform der Erfindung an Hand eines Beispiels erläutert. Es zeigt die
- **Fig.:**: schematisch eine erfindungsgemäße Vorrichtung mit Ausbildung eines invertierten Fireballs.

In der **Fig.** ist eine Anordnung der wesentlichen Elemente in einer Reaktionskammer der erfindungsgemäßen Vorrichtung 1 schematisch dargestellt. Die Reaktionskammer wird von den Reaktionsgasen durchströmt, wobei eine zusätzliche Anregung der Reaktionsgase durch die beschleunigten Elektronen eines Plasmas erfolgt. In der Reaktionskammer ist eine elektrisch leitende, mit einer Gleichspannungsquelle 4 positiv vorgespannte Gitterelektrode 2 angeordnet. Die Gitterelektrode 2 - hier schematisch durch eine ebene Seitenfläche dargestellt - formt einen Hohlraum, in dem sich ab einer bestimmten Größe der Vorspannung 4 ein invertierter Fireball 6 ausbildet. Der Hohlraum ist in dem dargestellten Beispiel quader- oder würfelförmig ausgeführt, kann aber auch kugelförmig ausgebildet sein. Im unteren Bereich des Fireballs 6 ist in einem Gebiet erhöhter Ionenkonzentration ein Substrat 8 gegenüber der Gitterelektrode 2 elektrisch isoliert auf einem keramischen Isolator 10 angeordnet. An der durch Erhitzung oder Kühlung auf eine vorgegebene Temperatur gebrachten Oberfläche des Substrats 8 wird ein Feststoff auf Grund der chemischen Reaktionen der zugeführten Reaktionsgase abgeschieden und bewirkt dort ein Schichtwachstum 12.

## Patentansprüche

1. Verfahren zur Beschichtung von Oberflächen eines Substrats nach der Methode der Plasma-unterstützten chemischen Gasphasenabscheidung,
**dadurch gekennzeichnet, dass**
die Plasmadichte eines existierenden Hintergrundplasmas an der Oberfläche des Substrats (8) durch die Bildung eines als Fireball (6) charakterisierten zusätzlichen Ionisierungsprozesses erhöht wird, der sich an einer positiv vorgespannten (4) Elektrodenoberfläche (2) einer Elektrode (2) zu einem dreidimensionalen Gebilde ausbildet, wenn die angelegte positive Spannung (4) an der Elektrode (2) das Ionisierungspotential des plasmabildenden Prozessgases übersteigt, wobei der Fireball (6) als invertierter Fireball (6) angeregt wird, dessen Ausbildung in dem Innenraum einer hohlraumbildenden Gitterelektrode (2) erfolgt durch die von dem Gitterpotential beschleunigten Elektronen, die nicht von der Gitterelektrode (2) absorbiert werden und zusätzliche Stoßionisationen hervorrufen.

2. Verfahren nach Anspruch 1,
**dadurch gekennzeichnet, dass**
an das Substrat (8) eine elektrische Vorspannung angelegt wird.

3. Verfahren nach Anspruch 1 oder 2,
**dadurch gekennzeichnet, dass**
das Hintergrundplasma durch Laserstrahlung angeregt wird.

4. Verfahren nach einem der Ansprüche 1 bis 3,
**dadurch gekennzeichnet, dass**
das Hintergrundplasma durch Zufuhr elektrischer und/oder magnetischer Energie angeregt wird.

5. Verfahren nach einem der Ansprüche 1 bis 4,
**dadurch gekennzeichnet, dass**
die Energiezufuhr pro Zeiteinheit in das Hintergrundplasma nach Ausbildung des Fireballs (6) verringert wird.

6. Verfahren nach einem der Ansprüche 1 bis 5,
**dadurch gekennzeichnet, dass**
aus Methan und Wasserstoff eine Diamantschicht abgeschieden wird.

7. Verfahren nach einem der Ansprüche 1 bis 6,
**dadurch gekennzeichnet, dass**
dem Reaktionsgas eine organische Borverbindung zugegeben wird und auf diese Weise eine mit Bor dotierte Diamantschicht abgeschieden wird.

8. Verfahren nach einem der Ansprüche 1 bis 5,
**dadurch gekennzeichnet, dass**
einer der folgenden Abscheidungsprozesse abläuft:
- aus Ammoniak und Dichlorsilan wird eine Siliziumnitrid-Schicht abgeschieden,
- aus Silan und Sauerstoff oder Tetraethylorthosilikat wird eine Siliziumoxid-Schicht abgeschieden,
- aus Wolframhexafluorid wird eine Silizium/Metall-Verbindung abgeschieden,
- aus Wasserstoff und Methylen-Trichlor-Silan wird eine Siliziumcarbid-Schicht abgeschieden
- aus Tetrakis(dimethylamino)titan 1 (TDMAT) und Stickstoff wird Titannitrid abgeschieden,
- aus organischen Verbindungen werden Silicide abgeschieden,
- aus Zinn-Chlorid oder Zinn-organischen Verbindungen werden mit Wasserdampf oder Sauerstoff Zinnoxid-Schichten auf Glas beschichtet,
- Borcarbid wird abgeschieden.

9. Vorrichtung zur Beschichtung von Oberflächen eines Substrats (8) nach der Methode der Plasma-unterstützten chemischen Gasphasenabscheidung in einer Reaktionskammer mit Hintergrundplasma,
**gekennzeichnet durch**
eine in der Reaktionskammer angeordnete, mit einer Gleichspannungsquelle (4) positiv vorgespannte (4) Elektrodenoberfläche (2) zur Ausbildung eines als Fireball (6) charakterisierten zusätzlichen Ionisierungsprozesses, wobei die Elektrodenoberfläche (2) als hohlraumbildende Gitterelektrode (2) ausgeführt ist, in deren Innenraum sich ein invertierter Fireball (6) ausbildet.

10. Vorrichtung nach Anspruch 9,
**dadurch gekennzeichnet, dass**
das Substrat (8) elektrisch isoliert im Wirkungsbereich des Fireballs (6) angeordnet ist.

11. Vorrichtung nach Anspruch 9 oder 10,
**dadurch gekennzeichnet, dass**
das Substrat (8) aus elektrisch leitfähigem Material besteht.

12. Vorrichtung nach einem der Ansprüche 9 bis 11,
**dadurch gekennzeichnet, dass**
das Substrat (8) aus Metall oder Graphit oder Siliziumcarbid oder Silizium oder einem Komposit aus diesen Substanzen oder einer Mischung aus diesen Substanzen besteht.

13. Vorrichtung nach einem der Ansprüche 9 bis 12,
**dadurch gekennzeichnet, dass**
die hohlraumbildenden Gitterelektrode (2) aus Wolfram besteht.

## Claims

1. A method for coating surfaces of a substrate according to the technique of plasma-assisted chemical vapor deposition, **characterized in that**
the plasma density of an existing background plasma at the surface of the substrate (8) is increased by the formation of an additional ionization process which is characterized as a fireball (6) and which forms a three-dimensional structure at a positively biased (4) electrode surface (2) of an electrode (2) if the applied positive voltage (4) at the electrode (2) exceeds the ionization potential of the plasma-forming process gas, said fireball (6) being excited as an inverted fireball which forms within the interior of a cavity-forming grid electrode (2) because of the electrons that are accelerated by the grid potential and not absorbed by the grid electrode (2) and that cause additional impact ionizations.

2. The method according to claim 1,
**characterized in that**
an electrical bias is applied to the substrate (8).

3. The method according to claim 1 or 2,
**characterized in that**
the background plasma is excited by laser radiation.

4. The method according to any one of claims 1 to 3, **characterized in that**
the background plasma is excited by supplying electrical and/or magnetic energy.

5. The method according to any one of claims 1 to 4, **characterized in that**
the supply of energy per unit of time into the background plasma is reduced once the fireball (6) has formed.

6. The method according to any one of claims 1 to 5, **characterized in that**
a diamond layer is deposited from methane and hydrogen.

7. The method according to any one of claims 1 to 6, **characterized in that**
an organic boron compound is added to the reaction gas and thus a boron-doped diamond layer is deposited.

8. The method according to any one of claims 1 to 5, **characterized in that**
one of the following deposition processes takes place:
- a silicon nitride layer is deposited from ammonia and dichlorosilane,
- a silicon oxide layer is deposited from silane and oxygen or tetraethyl orthosilicate,
- a silicon/metal compound is deposited from tungsten hexafluoride,
- a silicon carbide layer is deposited from hydrogen and methylenetrichlorosilane,
- titanium nitride is deposited from tetrakis(dimethylamino)titanium 1 (TDMAT) and nitrogen,
- silicides are deposited from organic compounds,
- tin oxide layers are coated onto glass from tin chloride or organotin compounds by means of water vapor or oxygen,
- boron carbide is deposited.

9. A device for coating surfaces of a substrate (8) according to the technique of plasma-assisted chemical vapor deposition in a reaction chamber with background plasma,
**characterized by**
a electrode surface (2) which is disposed in the reaction chamber and positively biased (4) by a DC voltage source (4) and serves to form an additional ionization process characterized as a fireball (6), said electrode surface (2) being configured as a cavity-forming grid electrode (2) in whose interior an inverted fireball (6) forms.

10. The device according to claim 9,
**characterized in that**
the substrate (8) is disposed in the sphere of action of the fireball (6) in an electrically isolated manner.

11. The device according to claim 9 or 10,
**characterized in that**
the substrate (8) is made of an electrically conductive material.

12. The device according to any one of claims 9 to 11, **characterized in that**
the substrate (8) is made of metal or graphite or silicon carbide or silicon or of a composite of said substances or of a mixture of said substances.

13. The device according to any one of the claims 9 to 12, **characterized in that**
the cavity-forming grid electrode (2) is made of tungsten.

## Revendications

1. Procédé de revêtement des surfaces d'un substrat selon la méthode de dépôt chimique en phase vapeur assisté par plasma,
**caractérisé en ce que**
la densité d'un plasma de fond existant à la surface du substrat (8) est augmentée par la réalisation d'un processus d'ionisation supplémentaire qui est caractérisé comme boule de feu (6) et qui se forme comme formation à trois dimensions sur une surface d'électrode (2) polarisée positivement (4) d'une électrode (2) quand la tension positive (4) appliquée à l'électrode (2) dépasse le potentiel d'ionisation du gaz de processus qui forme le plasma, ladite boule de feu (6) étant excité comme boule de feu (6) invertie, dont la formation s'effectue à l'intérieur d'une électrode de grille (2), qui forme une cavité, par les électrons accélérés par le potentiel de grille qui ne sont pas absorbés par l'électrode de grille (2) et provoquent des ionisations par impact supplémentaires.

2. Procédé selon la revendication 1,
**caractérisé en ce qu'**
une polarisation électrique est appliquée au substrat (8).

3. Procédé selon la revendication 1 ou 2,
**caractérisé en ce que**
le plasma de fond est excité par rayonnement laser.

4. Procédé selon l'une quelconque des revendications 1 à 3, **caractérisé en ce que**
le plasma de fond est excité par alimentation en énergie électrique et/ou magnétique.

5. Procédé selon l'une quelconque des revendications 1 à 4, **caractérisé en ce que**
l'alimentation du plasma de fond en énergie par unité de temps est réduite après la formation de la boule de feu (6).

6. Procédé selon l'une quelconque des revendications 1 à 5, **caractérisé en ce qu'**
une couche de diamant est déposée à partir de méthane et d'hydrogène.

7. Procédé selon l'une quelconque des revendication 1 à 6, **caractérisé en ce qu'**
un composé de bore organique est ajouté au gaz de réaction et de telle manière une couche de diamant dopée au bore est déposée.

8. Procédé selon l'une quelconque des revendications 1 à 5, **caractérisé en ce qu'**
un des processus de dépôt suivants s'effectue :
- une couche de nitrure de silicium est déposée à partir d'ammoniac et de dichlorosilane,
- une couche d'oxyde de silicium est déposée à partir de silane et d'oxygène ou d'orthosilicate de tétraéthyle,
- un composé de silicium/métal est déposé à partir d'hexafluorure de tungstène,
- une couche de carbure de silicium est déposée à partir d'oxygène et de méthylènetrichlorosilane,
- du nitrure de titane est déposé à partir de tétrakis(diméthylamino)titane 1 (TDMAT) et de l'azote,
- des siliciures sont déposés à partir de composés organiques,
- des couches d'oxyde stannique sont revêtues sur verre à partir de chlorure d'étain ou de composés organostanniques à laide de la vapeur d'eau ou de l'oxygène,
- du carbure de bore est déposé.

9. Dispositif de revêtement des surfaces d'un substrat (8) selon la méthode de dépôt chimique en phase vapeur assisté par plasma dans une chambre à réaction avec du plasma de fond,
**caractérisé par**
une surface d'électrode (2) disposé dans la chambre à réaction et polarisée positivement (4) par une source de tension continue (4) pour la réalisation d'un processus d'ionisation supplémentaire caractérisé comme boule de feu (6), ladite surface d'électrode (2) étant réalisée comme électrode de grille (2) qui forme une cavité et dans l'intérieure de laquelle se forme une boule de feu (6) invertie.

10. Dispositif selon la revendication 9,
**caractérisé en ce que**
le substrat (8) est disposé de manière électriquement isolée dans la zone effective de la boule de feu (6).

11. Dispositif selon la revendication 9 ou 10,
**caractérisé en ce que**
le substrat (8) se constitue du matériel électriquement conducteur.

12. Dispositif selon l'une quelconque des revendications 9 à 11, **caractérisé en ce que**
le substrat (8) se constitue de métal ou de graphite ou de carbure de silicium ou de silicium ou d'un composite de ces substances ou d'un mélange de ces substances.

13. Dispositif selon l'une quelconque des revendications 9 à 12, **caractérisé en ce que**
l'électrode de grille (2) qui forme la cavité se constitue de tungstène.
